# EUROPEAN PATENT SPECIFICATION

(11) **EP 1 287 561 B1**
(45) Date of publication and mention of the grant of the patent: **03.05.2006**
(21) Application number: 01934193.2
(22) Date of filing: 01.06.2001
(51) Int. Cl.: H01L 27/00, H01L 51/40

(54) **A METHOD OF CREATING A COLOR OPTOELECTRONIC DEVICE**
VERFAHREN ZUR ERZEUGUNG EINER FARBELEKTROOPTISCHEN VORRICHTUNG
PROCEDE DE PRODUCTION D'UN DISPOSITIF OPTOELECTRONIQUE COULEUR

(30) Priority: 01.06.2000 GB 0013394
(43) Date of publication of application: 05.03.2003
(73) Proprietor: Microemissive Displays Limited, Edinburgh EH9 3JF (GB)
(72) Inventor: WRIGHT, Jeffrey, Peter, Edinburgh EH7 5RJ (GB)
(74) Representative: Hanson, William Bennett
(86) International application number: PCT/GB2001/002449
(87) International publication number: WO 2001/093332

(56) References cited:
- WO-A-97/33737
- WO-A-99/54786
- PATENT ABSTRACTS OF JAPAN vol. 1999, no. 08, 30 June 1999 (1999-06-30) -& JP 11 074076 A (SEIKO EPSON CORP), 16 March 1999 (1999-03-16)
- PATENT ABSTRACTS OF JAPAN vol. 017, no. 593 (E-1454), 28 October 1993 (1993-10-28) -& JP 05 182763 A (SEKISUI CHEM CO LTD), 23 July 1993 (1993-07-23)

## Description

The present invention relates to a method of creating a color optoelectronic device.

Certain organic materials are known to emit light under electrical stimulation and are hence used in organic light emitting diodes (OLEDs). This can occur for small molecules and polymer materials (in polymer light emitting diodes - PLEDs). These materials require different processes for practical manufacture into display devices. Small molecule materials are deposited onto a substrate by vapor deposition whilst polymers are cast onto a substrate from a solution by spin-coating, printing, doctor blading, or a reel-to-reel process. Color arrays of three different small molecules (emitting red, green, and blue light) have been demonstrated by controlled vapor deposition, and recently ink-jet printed color pixel arrays of PLEDs have been demonstrated. A combination of the three primary colors creates full color imagery.

These manufacturing developments facilitate the production of medium to large sized OLED and PLED displays which may have pixel sizes in a range from 50 µm to 5 mm in size.

However, for certain applications there is a requirement to have color pixel arrays of a sub-50µm size, with 10µm being desirable. For OLED small molecules, it is conceivable that vapor deposition can provide suitable resolution for these purposes. However, for PLEDs none of the methods mentioned above are suitable.

Whilst ink-jet printing can provide a method of generating droplets of a suitable size, the spreading on the target substrate cannot be controlled to a high enough degree to produce regular shaped pixels of circa 10µm size. Conventional photolithography, using PLED materials, has been attempted, in conjunction with spin-coating and printing, but has not been optimized successfully. The emissive properties of the organic light emitting materials (both small molecule and PLED) and device lifetime are degraded by exposure to water, oxygen and some organic solvents. Conventional photoresists are applied by spin-coating from solution and developed by exposure to organic solvents and/or aqueous solutions. This process has to date proved incompatible with obtaining a device with sufficiently long lifetime.

Another disadvantage of the use of conventional lithography for the creation of a full color pixel array, in which neighboring pixels are arranged such that they emit red, green, and blue light, is that there is considerable waste of the semiconductor PLED (or small molecule) materials. The waste occurs because photolithography relies on the removal of material that has been applied to an underlying substrate to create the pattern and definition of the said material. This leads to considerable waste when three different light emitting materials have to be deposited, and increases the exposure to photoresist development processes. For effective diode performance the polymer materials, in particular, require considerable purification and therefore any wasted material impacts on the overall cost effectiveness of the manufacturing process.

It is therefore one aim of the invention to provide a method of creating an array of OLED (PLED or small molecule) pixels that is both efficient and economic.

WO 99/54786 A (JACKMAN REBECCA J ;MASSACHUSETTS INST TECHNOLOGY (US); WHITESIDES), 28 October 1999, discloses a combination of two masks used to selectively expose recesses in the lower mask. The lower mask remains in place throughout the deposition process. In order to deposit different emitter materials, the upper mask is repeatedly removed and realigned to expose different sets of recesses in the lower mask. In another example of this document, three sets of masks are stacked on a substrate. The masks are in register with each other such that in some cases channels of all three masks are in register with each other, and in other cases channels of two masks only are in register with each other and in other cases a channel of any one mask is not in register with any channel of any other mask. A first emitter material is deposited at those regions in which the channels of all three masks are in alignment, and following removal of the top mask, a second emitter material is deposited at those regions where the two remaining masks are in register with each other. Following removal of the middle mask, a third emitter material is deposited at those regions which are exposed by the bottom mask.

Accordingly, the present invention provides a method of creating an array of organic light emitting diode pixels as defined in claim 1.

Preferably, filling of the mold takes place by capillary action.

The method is primarily suited for the preparation of an array of pixels which have pixel widths or sizes of less than 50µm, but can also be used to create arrays of larger pixels.

The method is compatible with multi-layer structures.

Preferably, the organic light emitting material comprises a. polymer, but it may alternatively comprise amonomer or small molecule material.

The organic light emitting material may be in solution in a solvent, and may form solid-state structures by evaporation of the solvent at an ambient, elevated or controlled temperature,

The organic light emitting material may alternatively be in a pure form that flows and can be transformed to a non-flowing solid-state structure while in situ in the mold. As a further alternative, the organic light emitting material may be incorporated within a flowing material that can be transformed to a non-flowing solid-state structure while in situ in the mold. This flowing material may comprise a monomer, elastomer, crosslinking or polymerizing liquid crystal mixture, or a combination thereof.

The liquid filling the mold may be changeable to a solid-state structure by the action of at least one of heat, ultra-violet, x-ray, gamma ray exposure, and solvent evaporation.

As a preliminary step, the mold is conveniently cast against a master that has a patterned upper surface, from which master the mold forms a pattern in relief.

The conduits may all be filled from a single access hole leading to all of the conduits, or from a series of access holes in the mold.

Where the filling liquid is a solution, it is held in place by the mold against the substrate until the solvent has completely evaporated. The evaporation occurs before removal of the mold, which is removed from the substrate without damage to the solid patterned polymer or other light emitting material which has adhered to the substrate.

To create a multicolor (preferably three color) PLED pixel array, in one embodiment, a different mold is used for each different light emitting polymer material, with the mold cast from a. master that has only one third of the regularly positioned pixel arrays patterned on its surface: Each pixel recess in the mold then has an individual capillary access hole for introducing the polymer solution into. The holes may be created in the molding process from the pattern/structure on the master and allow the solution to be deposited onto the arbitrarily flat surface of the upper mold surface before flowing down via the capillary access holes through the conduits into the pixel molds. This process is then repeated subsequently with the next polymer material solutions (two more in this example) that emit separate colors of light by electroluminescence; being molded into individual pixels in the regular array.

In an alternative method not in accordance with the invention, one mold is constructed to allow selective filling of pixels. This allows, for example, all the blue light emitting pixels to be molded firstly by a network of adjoining capillaries or conduits that fill from a common access hole (or holes). The entrance(s) to the access hole(s) and the adjoining capillary network are then blocked using a suitable photoresist or metal. A second access hole (or holes) is then unblocked by selective metal lift-off or resist development, which allows filling of a further set of pixels via a second capillary network. This process is then repeated with a third fill/access hole(s) to the last network of pixels being uncovered and solution filled. For those skilled in the art it is possible to see how this may be done without the use of covering and uncovering access holes, by controlling the relevant position of the access holes to each other and or in addition to controlling the deposition of the different polymer solutions adjacent to their appropriate holes. The advantage of doing so would be a further reduction in the number of process steps and overall time required.

Another mold can then be applied, if necessary, or desirable, to the substrate after the molding of the light emitting pixels. This mold is filled with a non-light emitting material, which may be non-conducting, conducting, or a semi-conductor. The material could be a polymer in solution, or fill the mold as a fluid pre-polymer material, which could be cross-linked or solidified by the action of heat or ultraviolet light or a similar method. This material would form a network around the pixels filling completely, or partially, the gap spaces between adjacent pixels. This can provide further advantages by serving to electrically isolate each pixel from every other pixel, and/or also to direct light upwards and more perpendicularly to the display. This can prohibit a degradation in contrast caused by lateral light emission from neighboring pixels. The material can be chosen to be absorptive, typically a black material, to enhance the contrast. Alternatively, the material could be reflective. This material may not necessarily be an organic material. For those skilled in the art it can be seen that it is possible to mold this non-pixel material prior to creating the pixel array, or at some intermediate stage when the three-mold method is used to create the pixel array.

For multi-layer fabrications further molds can be applied over the pixels and further solutions filled. Care must be taken to ensure that any solvent of the ensuing material does not redissolve the previously molded materials.

For all the molds and the filling process(es), it is advantageous if a reservoir of a solution exists at the access holes that lead into the conduits. This allows continuous filling of the conduits or capillaries, and solution flow, as the solvent evaporation occurs. The solvent evaporation can lead to volume contraction and non-uniform filling of (in this case) the pixel mold areas. If the pixel areas fill before solution from the reservoirs is exhausted a tightly packed polymer microstructure confonning to the mold shape can be produced. Uniform filling and molding has been demonstrated to the sub-micron level using polyaniline solutions.

For all filling processes it may also be advantageous to employ a complete or partial vacuum to aid filling. Under these conditions the substrate and mold can be either brought together in a vacuum environment, or assembled in a chamber and then the chamber evacuated. The solution(s) is/are then applied to the access holes as a partial vacuum is created, with the introduction of a gas to the previously evacuated chamber. This aids the flow of solution into the mold. The gas introduced to the previously evacuated chamber may be an inert gas such as argon, or nitrogen or a reactive gas that reacts with oxygen or water such as, for example trimethylaluminum gas. Other reactive gases are known in the art.

In a similar effort to aid complete filling of the mold and pixel recesses, it may be advantageous to use a high pressure environment, where further inert or reactive gas is introduced to a chamber to aid filling.

Care must be taken to match the properties of the solvent, used to dissolve the PLED or other light emitting material, to that of the mold material so that no change occurs to the mold during the evaporation process. Specific solvents can cause certain polymers to swell or even dissolve completely. However, through careful matching the process can occur without physical change to the molds, which can be suitable for reuse.

The mold can be cast from a number of materials. It is known that using a liquid elastomer (pre-polymer) of for example, poly(dimethylsiloxane) (PDMS) can create sufficiently rugged molds. The elastomer is applied to an upper surface of the master mold, which is patterned by the use of photolithography, micromachining, or other semiconductor techniques to form the appropriate pattern/structure. This pattern can include the capillary channels(s), a capillary network, and the pixel areas. The elastomer conforms to the shape and pattern of the master mold, and is cross-linked by thermal or UV exposure to form a solid mold that can be peeled from the master. The mold replicates the surface of the master in relief. To those skilled in the art, many other pre-polymer materials will be obvious for use in conjunction with appropriate solvents that do not cause their swelling. Methylacrylate is another such example. Whilst polymer molds appear to be the most suitable it is possible that certain ceramic or other materials that allow for solvent evaporation may be appropriate molds, and could be cast in a similar manner and useful in certain circumstances with certain solvents/solutions.

Prior to positioning the mold can be flushed with the appropriate solvent that is to be used in conjunction with the PLED or other light emitting material. The PDMS mold can then be accurately aligned onto the display substrate. The positioning can be eased by the creation of interengaging means such as features created in the mold which fit into position with an identical pattern created on the substrate. The display substrate may be a transparent medium such as glass or plastic, or a silicon wafer, or similar that has been used or postulated for use in displays. The substrate may have any number of further surface treatments, or material depositions prior to the molding process occurring.

The mold is filled by the capillary action as described previously. The solvent is then evaporated. This can occur at room temperature or elevated temperature as long as care is taken to control the evaporation so that complete filling of the polymer pixels areas occur prior to complete solidification of the capillary channels.

The method described herein is also not limited to PLED or OLED solvent solutions but can be used with other flowing systems that have sufficiently low viscosity to fill the mold. These may be mixtures of the light emitting material with an elastomer or prepolymer material, that is then hardened/polymerized/cross-linked in the mold by the action of heat, UV light, x-rays or similar. The fluid may be a pure pre-polymer that when cross-linked or polymerized in the mold forms the light emitting polymer. Other combinations to effect the correct low viscosity to allow filling, and subsequent hardening or setting in the mold, will be known to those skilled in the art and are herein incorporated.

This method of molding and filling by capillary action has now been demonstrated for creating networks, or features, of conducting polymer material with in some cases submicron definition, using polyaniline in N-methyl-2-pyrrolidone(NMP) or m-cresol solvents.

The method described here covers the molding of suitably sized PLED or other light emitting materials to form one element of a light emitting diode pixel array. The technique is not limited to the light-emitting layer and can be used to pattern other organic materials, which serve as part of the diode structure of a PLED or other OLED pixel. For instance, the method can be used with hole transport or electron transport materials that are commonly found in organic light emitting diode structures.

The technique may also be used to form all or part of an electrode of the diode structure.

The present invention will now be described in more detail, by way of example only, with reference to the accompanying drawings, in which:
Figure 1 is a schematic view of a master for creating a mold for use in a method according to the invention;
Figure 2 schematically shows a mold cast from the master of Figure 1;
Figure 3 schematically shows the mold of Figure 2 filled with flowing material;
Figure 4 schematically shows a PLED array created after removal of the mold of Figures 2 and 3;
Figure 5 schematically shows another example of a mold in place on a substrate for use in a method according to the invention; and
Figure 6 schematically shows a mold in place on a substrate not in accordance with the invention.

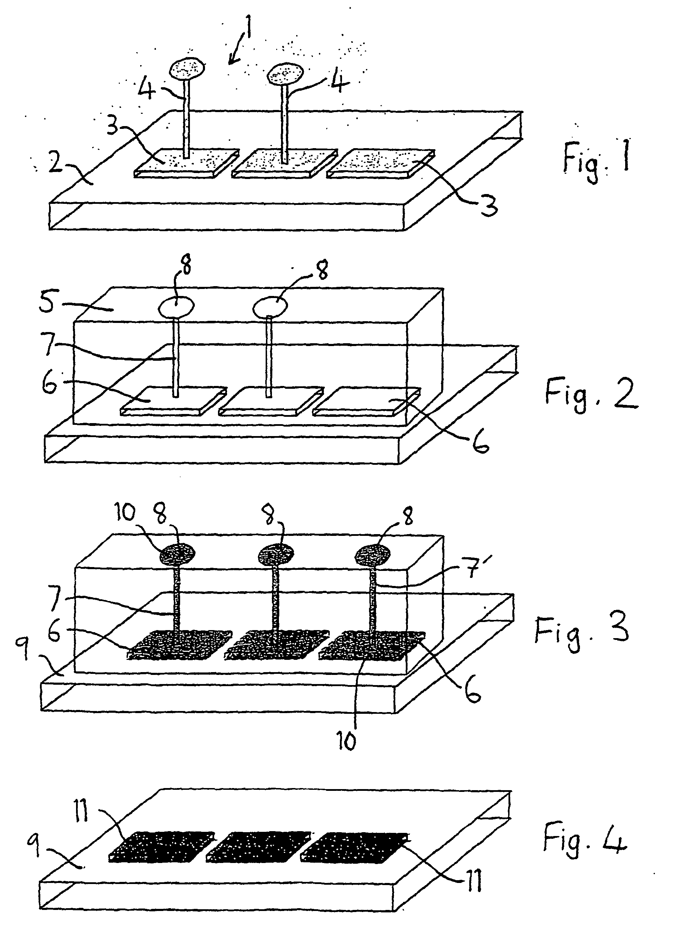

As shown in Figure 1, a master 1 is formed by patterning suitable photoresist and/or metals on a master substrate 2 to create the desired pattern or structure against which the mold is to be cast. In this example, the structure includes three pixel parts 3, two of which have filling capillary parts 4. The structure 3, 4 is created using techniques known in the art of semiconductor processing.

Figure 2 shows a mold 5 which has been created by casting an elastomer against the master 1, allowing it to harden and then peeling it off. The mold defines a relief image of the master and includes pixel recesses 6 and filling capillaries 7 each with an access hole 8.

Figure 3 shows the mold after a further filling capillary 7' has been cut thereinto allow access to one of the pixels recesses 6. The mold is positioned over a device substrate 9 and a solution 10 comprising a PLED material is allowed to flow into the access holes 8, filling the capillaries 7, T and the pixel recesses 6.

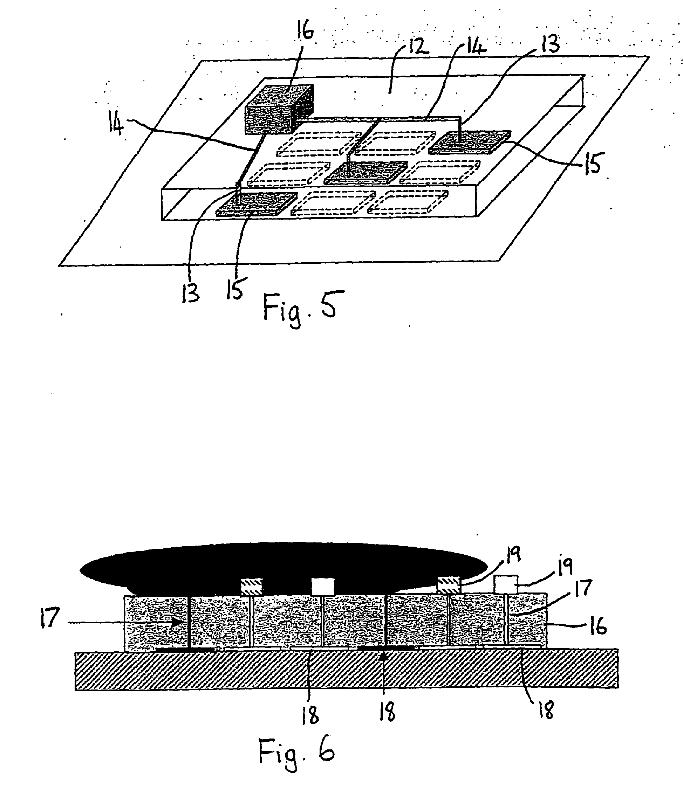

Figure 4-shows the finished array of pixels 11 after the solvent has evaporated, leaving the solid PLED material, and the mold has been removed.

Figure 5 shows an alternative mold 12 with defined vertical capillary channels 13 creating during molding, and horizontal connecting channels 14 cut into the upper surface of the mold. The flowing material fills selected pixel recesses 15 in the desired array. The polymer solution is enclosed in a reservoir 16 on the uppermost surface of the mold 12 in this example. The intended positions for the other pixels are shown in dashed lines and are filled using another mold (not shown) having an appropriate network of channels to allow further selective filling.

Figure 6 shows another alternative mold 16 not in accordance with the invention in schematic section. Individual filling capillaries 17 for pixel recesses 18 are accessed in a controlled manner from the upper surface of the mold 16. Certain of the capillaries are prevented from filling by means of photoresist or metal caps 19 which have been applied using standard semiconductor patterning techniques. Capillaries that have been filled can be selectively blocked in a similar manner, to prevent contamination from further solutions used for filling or to clean the upper surface of the mold.

## Claims

1. A method of creating an may of organic light emitting diode pixels, comprising the steps of:
providing a first mold (5, 12) including recesses (6, 15) for defining pixels and conduits (7,7', 13,14) leading to the recesses,
positioning the first mold so that the recesses are on a substrate (9),
filling all of the recesses (6,15) by means of all of the conduits (7, 7', 13, 14) with a liquid (10) comprising an organic light emitting material,
allowing the liquid in the recesses to form into solid pixel structures, and removing the first mold (5, 12);
**characterized by** the subsequent further steps of:
providing at least one further mold including further recesses for defining further pixels and further conduits leading to the further recesses,
positioning the at least one further mold so that the further recesses are on the substrate (9),
filling all of the further recesses by means of all of the further conduits with a further liquid comprising a further organic light emitting material,
allowing the further liquid in the further recesses to form into further solid pixel structures, and
removing the at least one further mold to leave the desired pixel array including said further pixel structures.

2. A method as claimed in claim 1, wherein in said first mold the organic light emitting material comprises a polymer.

3. A method as claimed in claim 1, wherein in said first mold the organic light emitting material comprises a small molecule material.

4. A method as claimed in claim 2 or 3, wherein in said first mold the organic light emitting material is in solution in a solvent.

5. A method as claimed in claim 4, wherein in said first mold the organic light emitting material forms solid-state structures (11) by evaporation of the solvent.

6. A method as claimed in claim 2 or 3, wherein in said first mold the organic light emitting material is in a pure form that flows and can be transformed to a non-flowing solid-state structure (11) while in situ in that mold.

7. A method as claimed in claim 2 or 3, wherein in said first mold the organic light emitting material is incorporated within a flowing material (10) that can be transformed to a non-flowing solid-state structure (11) while in situ in that mold.

8. A method as claimed in claim 7, wherein in said first mold the flowing material (10) comprises a monomer, elastomer, crosslinking or polymerizing liquid crystal mixture, or a combination thereof.

9. A method as described in any preceding claim, where in said first mold the liquid (10) filling that, mold (5, 12) changes to a solid-state structure by the action of at least one of heat, ultra-violet, x-ray, and gamma ray exposure.

10. A method as claimed in any preceding claim, comprising a preliminary step of casting the first mold (5) against a master (1) that has a patterned upper surface, from which master that mold (5) forms a pattern in relief.

11. A method as claimed in claim 10, wherein the first mold (5) is made from an elastomer, monomer or prepolymer which is hardened or polymerized in situ on the master (1).

12. A method as claimed in claim 11, wherein the first mold (5) is polymerized into a polymer, for example, poly(dimethylsiloxane) or poly(methylmethacrylate).

13. A method as claimed in any one of claims 1 to 10, wherein the first mold (5, 12) is of a ceramic material.

14. A method as claimed in any preceding claim, wherein in said first mold the conduits (13, 14) are filled from a single access hole leading to all of the conduits.

15. A method as claimed in any one of claims 1 to 13, wherein in said first mold the conduits (7, 7') are filled from a series of access holes (8) in that mold (5).

16. A method as claimed in claim 14 or 15, wherein a reservoir (16) of the liquid flowing into the first mold (12) is created around the access hole or holes.

17. A method as claimed in any preceding claim, wherein a non-light emitting material is introduced into the space between and around adjacent light emitting materials in the pixel array and molded onto the substrate (9).

18. A method as claimed in claim 17 comprising the streps of:
providing a mold including a recess for defining the space into which the non-light emitting material is to be introduced and a conduit leading to the recess,
positioning the mold so that the recess is in place on the substrate,
filling the recess by means of the conduit with a liquid comprising the non-light emitting material.
allowing the liquid in the recess to form into a solid structure, and removing the mold to leave the desired structure.

19. A method as claimed in any preceding claim, wherein filling of at least one of the molds (5,12) by the liquid takes place by capillary action.

20. A method as claimed in claim 19, wherein a vacuum environment is created around at least one of the molds (5, 12) and then reduced to a partial vacuum by the controlled introduction of a gas to aid the capillary filling of that mold.

21. A method as claimed in any one of claims 1 to 19, wherein a high pressure environment is created around at least one of the molds (5, 12) by introducing gas to aid the filling of that mold.

22. A method as claimed in claim 20 or 21, wherein the gas introduced is an insert gas 10 such as argon or nitrogen.

23. A method claimed in claim 20 or 21, wherein the gas introduced is a gas which is reactive with either oxygen or water vapor, for example, trimethyl aluminum.

24. A method as claimed in any preceding claim, wherein the substrate (9), and at least one of the molds (5) are provided with interengaging means to aid controlled positioning of that mold.

25. A method as claimed in any preceding claim, wherein at least one of the molds (5, 12) is flushed with an appropriate solvent prior to filling with the liquid (10).

## Revendications

1. Procédé de création d'un réseau de pixels de diodes électroluminescentes organiques, comprenant les étapes consistant à :
fournir un premier moule (5, 12) comportant des évidements (6, 15) pour définir des pixels et des conduits (7, 7', 13, 14) conduisant aux évidements,
positionner le premier moule de telle sorte que les évidements se trouvent sur un substrat (9),
remplir tous les évidements (6, 15) au moyen de tous les conduits (7, 7', 13, 14) avec un liquide (10) comprenant une matière électroluminescente organique,
laisser le liquide dans les évidements se former en structures de pixels solides, et
retirer le premier moule (5, 12) ;
**caractérisé par** les autres étapes ultérieures consistant à :
fournir au moins un autre moule comportant d'autres évidements pour définir d'autres pixels et d'autres conduits conduisant aux autres évidements,
positionner l'au moins un autre moule de telle sorte que les autres évidements se trouvent sur le substrat (9),
remplir tous les autres évidements au moyen de tous les autres conduits avec un autre liquide comprenant une autre matière électroluminescente organique,
laisser l'autre liquide dans les autres évidements se former en d'autres structures de pixels solides, et
retirer l'au moins un autre moule pour laisser le réseau de pixels désiré y compris lesdites autres structures de pixels.

2. Procédé selon la revendication 1, dans lequel dans ledit premier moule la matière électroluminescente organique comprend un polymère.

3. Procédé selon la revendication 1, dans lequel dans ledit premier moule la matière électroluminescente organique comprend une matière à molécules de petite taille.

4. Procédé selon la revendication 2 ou 3, dans lequel dans ledit premier moule la matière électroluminescente organique est en solution dans un solvant.

5. Procédé selon la revendication 4, dans lequel dans ledit premier moule la matière électroluminescente organique forme des structures à l'état solide (11) par évaporation du solvant.

6. Procédé selon la revendication 2 ou 3, dans lequel dans ledit premier moule la matière électroluminescente organique se présente sous une forme pure fluide et qui peut être transformée en une structure à l'état solide non fluide (11) lorsqu'elle est in situ dans ce moule.

7. Procédé selon la revendication 2 ou 3, dans lequel dans ledit premier moule la matière électroluminescente organique est incorporée dans une matière fluide (10) qui peut être transformée en une structure à l'état solide non fluide (11) lorsqu'elle est in situ dans ce moule.

8. Procédé selon la revendication 7, dans lequel dans ledit premier moule la matière fluide comprend un monomère, un élastomère, un mélange de cristaux liquides de réticulation ou de polymérisation, ou une combinaison de ceux-ci.

9. Procédé selon l'une quelconque des revendications précédentes, dans lequel dans ledit premier moule le liquide (10) remplissant ce moule (5, 12) change en une structure à l'état solide par l'action d'une exposition à au moins la chaleur, les ultraviolets, les rayons X et les rayons gamma.

10. Procédé selon l'une quelconque des revendications précédentes, comprenant une étape préliminaire de coulée du premier moule (5) contre un modèle (1) qui présente une surface supérieure dotée d'un motif, modèle à partir duquel ce moule (5) forme un motif en relief.

11. Procédé selon la revendication 10, dans lequel le premier moule (5) est réalisé à partir d'un élastomère, monomère ou prépolymère qui est durci ou polymérisé in situ sur le modèle (1).

12. Procédé selon la revendication 11, dans lequel le premier moule (5) est polymérisé en un polymère, par exemple, un poly(diméthylsiloxane) ou un poly(méthacrylate de méthyle).

13. Procédé selon l'une quelconque des revendications 1 à 10, dans lequel le premier moule (5, 12) est en une matière céramique.

14. Procédé selon l'une quelconque des revendications précédentes, dans lequel dans ledit premier moule les conduits (13, 14) sont remplis à partir d'un trou d'accès unique conduisant à tous les conduits.

15. Procédé selon l'une quelconque des revendications 1 à 13, dans lequel dans ledit premier moule les conduits (7, 7') sont remplis à partir d'une série de trous d'accès (8) dans ce moule (5).

16. Procédé selon la revendication 14 ou 15, dans lequel un réservoir (16) du liquide s'écoulant dans le premier moule (12) est créé autour du ou des trous d'accès.

17. Procédé selon l'une quelconque des revendications précédentes, dans lequel une matière non électroluminescente est introduite dans l'espace entre des matières électroluminescentes adjacentes dans le réseau de pixels et autour de celles-ci et moulée sur le substrat (9).

18. Procédé selon la revendication 17, comprenant les étapes consistant à :
fournir un moule comportant un évidement pour définir l'espace dans lequel la matière non électroluminescente doit être introduite et un conduit conduisant à l'évidement,
positionner le moule de telle sorte que l'évidement soit en place sur le substrat,
remplir l'évidement au moyen du conduit avec un liquide comprenant la matière non électroluminescente,
laisser le liquide dans l'évidement se former en une structure solide, et
retirer le moule pour laisser la structure désirée.

19. Procédé selon l'une quelconque des revendications précédentes, dans lequel le remplissage d'au moins l'un des moules (5, 12) par le liquide intervient par action capillaire.

20. Procédé selon la revendication 19, dans lequel un environnement de vide est créé autour d'au moins un des moules (5, 12) puis réduit à un vide partiel par l'introduction contrôlée d'un gaz afin d'aider au remplissage capillaire de ce moule.

21. Procédé selon l'une quelconque des revendications 1 à 19, , dans lequel un environnement à haute pression est créé autour d'au moins un des moules (5, 12) en introduisant un gaz afin d'aider au remplissage de ce moule.

22. Procédé selon la revendication 20 ou 21, dans lequel le gaz introduit est un gaz inerte tel que l'argon ou l'azote.

23. Procédé selon la revendication 20 ou 21, dans lequel le gaz introduit est un gaz qui réagit avec soit l'oxygène, soit la vapeur d'eau, par exemple du triméthyl-aluminium.

24. Procédé selon l'une quelconque des revendications précédentes, dans lequel le substrat (9) et au moins un des moules (5) sont munis de moyens d'interengagement afin d'aider au positionnement contrôlé de ce moule.

25. Procédé selon l'une quelconque des revendications précédentes, dans lequel au moins un des moules (5, 12) est purgé avec un solvant approprié avant le remplissage du liquide (10).

## Patentansprüche

1. Verfahren zum Herstellen eines Arrays von organischen Leuchtdiodenpixeln, mit den folgenden Schritten:
Bereitstellen einer ersten Form (5, 12) mit Vertiefungen (6, 15) zum Definieren von Pixeln und zu den Vertiefungen führenden Kanälen (7, 7', 13, 14),
Positionieren der ersten Form, so daß sich die Vertiefungen auf einem Substrat (9) befinden,
Füllen aller Vertiefungen (6, 15) mit Hilfe aller Kanäle (7, 7', 13, 14) mit einer Flüssigkeit (10), die ein organisches lichtemittierendes Material umfaßt
Ausbildenlassen der Flüssigkeit in den Vertiefungen zu massiven Pixelstrukturen und
Entfernen der ersten Form (5, 12);
**gekennzeichnet durch** die nachfolgenden weiteren Schritte:
Bereitstellen mindestens einer weiteren Form mit weiteren Vertiefungen zum Definieren weiterer Pixel und weiterer zu den weiteren Vertiefungen führender Kanäle,
Positionieren der mindestens einen weiteren Form so, daß sich die weiteren Vertiefungen auf dem Substrat (9) befinden,
Füllen aller weiteren Vertiefungen mit Hilfe aller weiteren Kanäle mit einer weiteren Flüssigkeit, die ein weiteres organisches lichtemittierendes Material umfaßt,
Ausbildenlassen der weiteren Flüssigkeit in den weiteren Vertiefungen zu weiteren massiven Pixelstrukturen und
Entfernen der mindestens einen weiteren Form, um das gewünschte Pixelarray mit den weiteren Pixelstrukturen zurückzulassen.

2. Verfahren nach Anspruch 1, wobei in der ersten Form das organische lichtemittierende Material ein Polymer umfaßt.

3. Verfahren nach Anspruch 1, wobei in der ersten Form das organische lichtemittierende Material ein kleinmoleküliges Material umfaßt..

4. Verfahren nach Anspruch 2 oder 3, wobei in der ersten Form das organische lichtemittierende Material sich in einer Lösung in einem Lösungsmittel befindet.

5. Verfahren nach Anspruch 4, wobei in der ersten Form das organische lichtemittierende Material durch Verdampfung des Lösungsmittels feste Strukturen (11) bildet.

6. Verfahren nach Anspruch 2 oder 3, wobei in der ersten Form das organische lichtemittierende Material in einer reinen Form vorliegt, das fließt und in eine nichtfließende feste Struktur (11) transformiert werden kann, während es sich in dieser Form in situ befindet.

7. Verfahren nach Anspruch 2 oder 3, wobei in der ersten Form das organische lichtemittierende Material in ein fließendes Material (10) eingearbeitet ist, das in eine nichtfließende feste Struktur (11) transformiert werden kann, während es sich in dieser Form in situ befindet.

8. Verfahren nach Anspruch 7, wobei in der ersten Form das fließende Material (10) ein Monomer, Elastomer, eine vernetzende oder polymerisierende Flüssigkristallmischung oder eine Kombination davon umfaßt.

9. Verfahren nach einem der vorhergehenden Ansprüche, wobei in der ersten Form die diese Form (5, 12) füllende Flüssigkeit (10) sich durch die Wirkung von mindestens einem von Wärme-, Ultraviolett-, Röntgenstrahlen- und Gammastrahlenexposition in einen festen Aggregatzustand verändert.

10. Verfahren nach einem der vorhergehenden Ansprüche, mit einem vorläufigen Schritt des Gießens der ersten Form (5) gegen eine Urform (1), die eine strukturierte obere Oberfläche aufweist, von welcher Urform diese Form (5) ein Muster im Relief bildet.

11. Verfahren nach Anspruch 10, wobei die erste Form (5) aus einem Elastomer, Monomer oder Vorpolymer hergestellt ist, das in situ auf der Urform (1) gehärtet oder polymerisiert werden kann.

12. Verfahren nach Anspruch 11, wobei die erste Form (5) zu einem Polymer polymerisiert wird, beispielsweise Polydimethylsiloxan oder Polymethylmethacrylat.

13. Verfahren nach einem der Ansprüche 1 bis 10, wobei die erste Form (5, 12) aus einem Keramikmaterial besteht.

14. Verfahren nach einem der vorhergehenden Ansprüche, wobei in der ersten Form die Kanäle (13, 14) aus einem einzelnen Zugangsloch gefüllt werden, das zu allen Kanälen führt.

15. Verfahren nach einem der Ansprüche 1 bis 13, wobei in der ersten Form die Kanäle (7, 7') aus einer Reihe von Zugangslöchern (8) in dieser Form (5) gefüllt werden.

16. Verfahren nach Anspruch 14 oder 15, wobei ein Behälter (16) der in die erste Form (12) fließenden Flüssigkeit um das oder die Zugangslöcher herum hergestellt ist.

17. Verfahren nach einem der vorhergehenden Ansprüche, wobei ein nicht-lichtemittierendes Material in den Raum zwischen und um benachbarte lichtemittierende Materialien in dem Pixelarray herum eingeleitet und auf dem Substrat (9) ausgebildet wird.

18. Verfahren nach Anspruch 17, mit den folgenden Schritten:
Bereitstellen einer Form mit einer Vertiefung zum Definieren des Raums, in den das nicht-lichtemittierende Material eingeleitet werden soll, und eines zu der Vertiefung führenden Kanals,
Positionieren der Form so, daß sich die Vertiefung auf dem Substrat befindet,
Füllen der Vertiefung mit Hilfe des Kanals mit einer das nicht-lichtemittierende Material umfassenden Flüssigkeit,
Ausbildenlassen der Flüssigkeit in der Vertiefung zu einer festen Struktur und Entfernen der Form, um die gewünschte Struktur zurückzulassen.

19. Verfahren nach einem der vorhergehenden Ansprüche, wobei das Füllen mindestens einer der Formen (5, 12) durch die Flüssigkeit durch Kapilarwirkung stattfindet.

20. Verfahren nach Anspruch 19, wobei um die mindestens eine der Formen (5, 12) herum eine Vakuumumgebung hergestellt und dann durch das gesteuerte Einleiten eines Gases zu einem Teilvakuum reduziert wird, um das kapillare Füllen dieser Form zu unterstützen.

21. Verfahren nach einem der Ansprüche 1 bis 19, wobei um die mindestens eine der Formen (5, 12) herum eine Hochdruckumgebung hergestellt wird durch Einleiten eines Gases, um das Füllen dieser Form zu unterstützen.

22. Verfahren nach Anspruch 20 oder 21, wobei das eingeleitete Gas ein inertes Gas wie etwa Argon oder Stickstoff ist.

23. Verfahren nach Anspruch 20 oder 21, wobei das eingeleitete Gas ein Gas ist, das entweder mit Sauerstoff oder Wasserdampf reagiert, beispielsweise Trimethylaluminium.

24. Verfahren nach einem der vorhergehenden Ansprüche, wobei das Substrat (9) und diese mindestens eine der Formen (5) mit Eingriffsmitteln versehen sind, um das kontrollierte Positionieren dieser Form zu unterstützen.

25. Verfahren nach einem der vorhergehenden Ansprüche, wobei mindestens eine der Formen (5, 12) vor dem Füllen mit der Flüssigkeit (10) mit einem entsprechenden Lösungsmittel gespült wird.
